Europäisches Patentamt

European Patent Office

Office européen des brevets

(11) Numéro de publication : **0 030 168**
**B1**

(12) **FASCICULE DE BREVET EUROPÉEN**

(45) Date de publication du fascicule du brevet :
**11.05.83**

(51) Int. Cl.³ : **H 01 L 25/04**

(21) Numéro de dépôt : **80401449.6**

(22) Date de dépôt : **09.10.80**

(54) Dispositif de mise en parallèle de transistors de puissance en très haute fréquence.

(30) Priorité : **21.11.79 FR 7928692**

(43) Date de publication de la demande :
**10.06.81 Bulletin 81/23**

(45) Mention de la délivrance du brevet :
**11.05.83 Bulletin 83/19**

(84) Etats contractants désignés :
**DE GB IT NL**

(56) Documents cités :
**DE A 2 731 211**
**FR A 2 069 787**
**FR A 2 308 205**

(73) Titulaire : **THOMSON-CSF**
**173, Boulevard Haussmann**
**F-75379 Paris Cedex 08 (FR)**

(72) Inventeur : **Resneau, Jean-Claude**
**"THOMSON-CSF" SCPI - 173, Bld Haussmann**
**F-75360 Paris Cedex 08 (FR)**
Inventeur : **Cirlo, Marius**
**"THOMSON-CSF" SCPI - 173, Bld Haussmann**
**F-75360 Paris Cedex 08 (FR)**
Inventeur : **Doyen, Jean**
**"THOMSON-CSF" SCPI - 173, Bld Haussmann**
**F-75360 Paris Cedex 08 (FR)**

(74) Mandataire : **Giraud, Pierre et al**
**THOMSON-CSF SCPI 173, Bld Haussmann**
**F-75379 Paris Cedex 08 (FR)**

Jouve, 18, rue St-Denis, 75001 Paris, France

## Dispositif de mise en parallèle de transistors de puissance en très haute fréquence

L'invention concerne un dispositif de mise en parallèle de transistors, en très haute fréquence, notamment ceux destinés à être placés entre une ligne d'entrée et une ligne de sortie à deux plans conducteurs parallèles. L'invention concerne également un amplificateur à très haute fréquence et à grande puissance, par exemple de 500 watts, utilisant un tel dispositif.

En très haute fréquence, notamment à partir du gigahertz, les transistors bipolaires sont fréquemment montés dans les circuits d'utilisation en isolant le collecteur de la masse. Il en résulte, en pratique, la nécessité d'isoler de la masse, la face postérieure du substrat du transistor, (celle qui est opposée à la face comportant les électrodes de base et d'émetteur).

Dans le cas d'un transistor de forte puissance, notamment à partir de quelques dizaines de watts, il devient impératif de dissiper les calories dégagées lors du fonctionnement du transistor. On interpose alors entre la masse et la face postérieure du substrat du transistor une plaque en oxyde de bérillium, matériau qui présente simultanément un bon pouvoir isolant, une bonne conductivité thermique et un coefficient de dilatation assez proche de celui du silicium. On est cependant limité dans cette voie par la dimension des plaques d'oxyde de béryllium utilisables, pour les transistors de très forte puissance, réalisés en pratique par une multiplicité de transistors monolithiques (« puces ») mis en parallèles. En effet, on doit redouter, lors de la soudure de la puce sur son support, des fêlures provenant de la très grande différence de coefficient de dilatation entre l'oxyde de béryllium et le cuivre du support. En outre, dans le cas où l'on utilise plusieurs « puces » de transistors, soit autant de substrats différents placés sur une même plaque d'oxyde de béryllium, on rencontre des difficultés pour les souder collectivement et pour effectuer les connexions de mise en parallèle de façon claire, sans risquer des mélanges indésirables.

L'invention permet de résoudre une grande part de ces difficultés.

Selon l'invention, un dispositif de mise en parallèle de 2n transistors (n étant un nombre entier égal ou supérieur à un) destinés à fonctionner à grande puissance, en très haute fréquence du type comportant une première plaque servant de plan de masse électrique et thermique et une deuxième plaque électriquement isolante, supportant deux plages métallisées, chaque transistor étant placé sur l'une de 2n plaquettes électriquement isolantes et thermiquement conductrices soudées à la première plaque, les transistors, rangés en n colonnes, étant insérés entre la première et la deuxième plaque, est caractérisé en ce que les plaquettes isolantes supportant les différents transistors sont munies de trois bornes au moins respectivement reliées à chacune des électrodes des transistors dont l'une est à la masse et les deux autres supportent des picots constituant des conducteurs traversant la deuxième plaque et venant raccorder respectivement l'une ou l'autre des plages métallisées.

L'invention sera mieux comprise, et d'autres caractéristiques apparaîtront au moyen de la description qui suit, et des dessins qui l'accompagnent, parmi lesquels :

la figure 1 est une vue en plan représentant schématiquement l'organisation de transistors de puissance ainsi que leur moyens de raccordement et leur disposition dans un fond de boîtier suivant un exemple de réalisation de l'invention ;

la figure 2 est une vue en perspective d'un des transistors dans l'exemple précité ;

la figure 3 est une vue en plan de la deuxième plaque portant des plages métallisées d'une configuration particulière à l'exemple de réalisation précité.

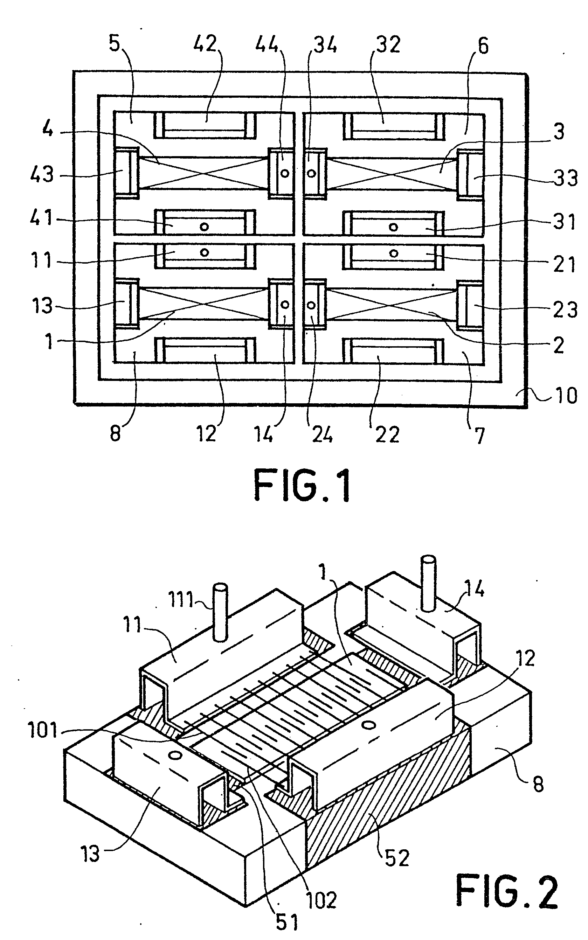

Dans la réalisation décrite ci-après, et illustrée par les figures 1 à 3, quatre transistors de puissance (de l'ordre de 100 watts chacun) sont placés comme l'indique la figure 1 dans le fond d'un boîtier rectangulaire 10 en cuivre doré. Ces transistors, par exemple bipolaires au silicium, sont monolithiques et représentés figure 1 de façon symbolique tandis qu'au contraire, à la figure 2, on a représenté deux peignes de connexions raccordées à des bornes 11 (de base) et 12 (d'émetteur). Il s'agit en fait d'une représentation encore très simplifiée. Sur chaque puce de silicium on trouve en effet :

a) une ou plusieurs rangées de transistors élémentaires comportant chacun une base et un émetteur en forme de peignes interdigités (non représentés), dont les connexions sont réalisées sous forme de métallisations déposées sur la silice recouvrant le silicium et convergent vers un certain nombre de points communs destinés au raccordement par fils aériens ;

b) des départs de connexions aériennes tels que le fil 101 (de base) et 102 (d'émetteur) vers les bornes 11 et 12 (figure 2) et, bien que non représentés figure 1, vers les bornes analogues 21 et 22 pour le transistor 2, 31 et 32 pour le transistor 3, etc...

Ces bornes, comme les puces de silicium elles-mêmes, sont soudées sur des plaquettes d'oxyde de béryllium 5 à 8, elles-mêmes soudées au fond du boîtier 10.

En outre, le collecteur du transistor est réalisé dans une région du substrat qui affleure à la face postérieure de celui-ci. Le substrat est lui-même soudé par cette face à une plage métallisée 51 de la plaquette 5. Cette plage a une surface qui déborde la puce et se prolonge sous les bornes 13 et 14, dont l'une ou l'autre peut servir de borne de collecteur. La plage métallisée 51 est visible figure 2 entre la puce 1 et les bornes 13 et 14. La borne utilisée pour le raccordement électrique avec le circuit extérieur au transistor est par exemple la borne 14 occupant, comme on le voit figure 1, une position plus centrale dans le boîtier que la borne 13.

Enfin la borne 12 est raccordée au fond du boîtier par l'intermédiaire d'une plage métallisée 52 déposée sur la tranche de la plaquette et débordant sur les deux grandes faces de celle-ci.

Les quatre bornes 11 à 14 d'un même transistor sont par exemple constituées à l'aide de bandes de cuivre doré repliées en forme d'U et soudées sur la plaquette 5. Les bornes 11 et 14 supportent des picots cylindriques (tels que 111 pour la borne 11) d'axes perpendiculaires au fond du boîtier. Les bornes 12 et 13 ne comportent pas de tels picots. Les picots des bornes 14, 24, 34 et 44 occupent une position plus centrale que les picots des bornes 11, 21, 31 et 41.

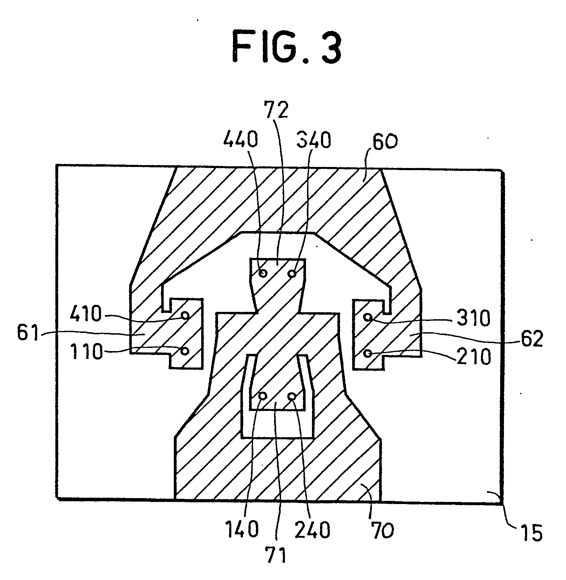

Figure 3 on a représenté une plaque 15 en céramique servant de couvercle au boîtier 10 en même temps que de surface de raccordement électrique des circuits d'entrée et de sortie d'un amplificateur dont le composant actif est constitué par l'ensemble des quatre transistors. Les plages de départ et/ou d'arrivée de ces circuits sont matérialisées sur la face supérieure du couvercle du boîtier par exemple par des conducteurs métalliques 60 et 70 qui sont par exemple des bandes en cuivre ou en nickel doré soudées sur la plaque 15.

Cette plaque 15 comporte elle-même huit perforations traversant de part en part la céramique et la plage métallique correspondante. On a attribué à ces perforations des repères 110, 210, 310 et 410 pour rappeler ceux des bornes des picots de base destinés à les traverser, et des repères 140, 240, 340 et 440 pour rappeler ceux des bornes des picots de collecteur destinés à les traverser, lorsqu'on referme le boîtier en utilisant à cet effet la plaque 15. Celle-ci comporte en outre, sur le pourtour de sa face opposée aux conducteurs 60 et 70, une métallisation destinée à permettre la soudure avec le rebord du boîtier 10 de façon à réaliser l'étanchéité du boîtier.

On notera que les conducteurs 60 et 70 ont des formes complémentaires, étudiées de façon à grouper les picots en deux ensembles de quatre : les perforations 110 à 410 sont groupées deux par deux sur deux plages métalliques 61 et 62 symétriques par rapport au centre de la plaque 15 et encadrent le conducteur 70 où deux plages 71 et 72 regroupent deux par deux les perforations 140 à 440. On assure ainsi la meilleure réduction possible des inductances parasites dans le cas d'un groupe de quatre transistors.

L'invention est applicable à des amplificateurs de puissance, en très haute fréquence, mettant en œuvre 2n transistors. Il suffit de ranger les transistors en n colonnes disposées sur la première plaque sur des plaquettes individuelles munies de bornes et de picots analogues à ceux du dispositif à 4 transistors. Les plages métalliques sont disposées de façon analogue à celle de la figure 3.

L'invention est applicable à des transistors à effet de champ dans lesquels les électrodes mises en parallèle sont d'une part les grilles et d'autre part les drains, les sources étant mises à la masse.

## Revendications

1. Dispositif de mise en parallèle de 2n transistors (1, 2, 3, 4) (n étant un nombre entier égal ou supérieur à un) destinés à fonctionner à grande puissance, en très haute fréquence du type comportant une première plaque (10) servant de plan de masse électrique et thermique et une deuxième plaque électriquement isolante (15), supportant deux plages métallisées (60, 70), chaque transistor étant placé sur l'une de 2n plaquettes (5 à 8) électriquement isolantes et thermiquement conductrices soudées à la première plaque (10), les transistors, rangés en n colonnes, étant insérés entre la première et la deuxième plaque, caractérisé en ce que les plaquettes isolantes supportant les différents transistors sont munies de trois bornes au moins (11, 12, 13, 14) respectivement reliées à chacune des électrodes des transistors dont l'une (12) est à la masse et les deux autres supportent des picots (111) constituant des conducteurs traversant la deuxième plaque et venant contacter respectivement l'une et l'autre des deux plages métallisées.

2. Dispositif selon la revendication 1, caractérisé en ce que les transistors sont contenus dans un boîtier dont le fond est constitué par la première plaque (10) et le couvercle par la deuxième plaque (15).

3. Dispositif selon l'une quelconque des revendications 1 et 2, caractérisé en ce que les premières (11) et deuxièmes électrodes (14) sont les bases et les collecteurs de transistors bipolaires, et les troisièmes électrodes (12) sont les émetteurs des transistors.

4. Dispositif selon l'une quelconque des revendications 1 et 2, caractérisé en ce que les premières et deuxièmes électrodes sont les grilles et les drains de transistors à effet de champ, et les troisièmes électrodes sont les sources des transistors.

5. Dispositif selon l'une quelconque des revendications 1 à 4, caractérisé en ce que les ensembles monolithiques sont en silicium, les plaquettes en oxyde de béryllium et la deuxième plaque est en céramique recouverte de plages métalliques.

6. Dispositif selon la revendication 2, caractérisé en ce que la deuxième plaque, électriquement isolante, est munie d'une métallisation sur ses bords de façon à ce qu'elle puisse être soudée au rebord du boîtier en assurant ainsi l'étanchéité de celui-ci.

## Claims

1. A device for shunting 2n transistors (1, 2, 3, 4) (n being an integer equal or superior to one) adapted to operate under high power and high frequency conditions, comprising a first plate (10) constituting an electric and thermal grounding plane, and a second electrically isolating plate (15) supporting two metallized areas (60, 70), each transistor being placed on one of 2n electrically isolating and thermally conductive plates (5 to 8) welded to said first plate (10), the transistors, which are arranged in n columns, being inserted between the first plate and the second plate, characterized in that the isolating plates supporting the different transistors are provided with at least three terminals (11, 12, 13, 14) connected respectively to each one of the electrodes of the transistors, one of said electrodes (12) being grounded, while the two other electrodes support studs (111) which constitute conductors extending through the second plate and contacting respectively one of said two metallized areas.

2. A device according to claim 1, characterized in that said transistors are contained in a casing the bottom of which is constituted by said first plate (10) and the cover of which is constituted by said second plate (15).

3. A device according to any one of claims 1 and 2, characterized in that the first (11) and second electrodes (14) are the bases and the collectors of bipolar transistors, while the third electrodes (12) are the emitters of said transistors.

4. A device according to any one of claims 1 and 2, characterized in that the first and second electrodes are the grids and the drains of field effect transistors, while the third electrodes are the sources of said transistors.

5. A device according to any one of claims 1 to 4, characterized in that the monolithic assemblies are made of silicon, the plates being made of beryllium oxide, while the third plate is made of a ceramic material covered with metallic zones.

6. A device according to claim 2, characterized in that the second electrically isolating plate is provided at its borders with a metallization layer so as to be able to be welded to the rim of said casing and thus ensure the tightness thereof.

**Ansprüche**

1. Vorrichtung zum Parallelschalten von 2n Transistoren (1, 2, 3, 4) (wo n eine ganze Zahl darstellt, die gleich oder grösser als eins ist), welche dazu bestimmt sind, mit hoher Leistung und sehr hoher ·Frequenz zu arbeiten und je eine erste, eine elektrische und thermische Erdungs-Ebene bildende Platte (10), sowie eine Zweite elektrisch isolierende Platte (15) aufweisen, welch letztere zwei metallisierte Bereiche (60, 70) trägt, wobei jeder Transistor auf einer von 2n elektrisch isolierenden und wärmerleitenden Platten (5 bis 8) angeordnet ist, die an die erste Platte (10) angeschweisst sind, und wobei die in n Kolonnen angeordneten Transistoren zwischen der ersten und der zweiten Platte angeordnet sind, dadurch gekennzeichnet, dass die die verschiedenen Transistoren tragenden isolierenden Platten mit wenigstens drei Klemmen (11, 12, 13, 14) versehen sind, deren jede mit jeweils einer der Elektroden der Transistoren verbunden ist, wobei eine der Elektroden (12) geerdet ist, während die beiden anderen Elektroden Stifte (111) tragen, welche die zwei Platte durchdringende und mit jeweils einem der beiden metallisierten Bereiche in Berührung stehende Leiter bilden.

2. Vorrichtung nach Anspruch 1, dadurch gekennzeichnet, dass die Transistoren in einem Gehäuse angeordnet sind, dessen Boden durch die erste Platte (10) und dessen Deckel durch die zweite Platte (15) gebildet ist.

3. Vorrichtung nach einem der Ansprüche 1 und 2, dadurch gekennzeichnet, dass die ersten (11) und zweiten Elektroden (14) die Basiselektroden und Kollektorelektroden zweipoliger Transistoren bilden, während die dritten Elektroden (12) die Emitterelektroden der Transistoren bilden.

4. Vorrichtung nach einem der Ansprüche 1 und 2, dadurch gekennzeichnet, dass die ersten und zweiten Elektroden die Gitter und die Drainelektroden von Feldeffekttransistoren bilden, während die dritten Elektroden die Quellenelektroden der Transistoren bilden.

5. Vorrichtung nach einem der Ansprüche 1 bis 4, dadurch gekennzeichnet, dass die monolithischen Bauteile aus Silizium, die Platten aus Berylliumoxyd und die zweite Platte aus mit metallischen Bereichen beschichtetem Keramikmaterial bestehen.

6. Vorrichtung nach Anspruch 2, dadurch gekennzeichnet, dass die elektrisch isolierende zweite Platte an ihren Rändern mit einer Metallisationsschicht versehen ist, derart, dass sie an den Flanschrand des Gehäuses anschweissbar ist und somit die Dichtigkeit des letzteren sichert.

FIG.1

FIG.2

# FIG. 3